# EUROPÄISCHE PATENTSCHRIFT

(11) **EP 2 729 962 B1**
(45) Veröffentlichungstag und Bekanntmachung des Hinweises auf die Patenterteilung: **13.11.2019**
(21) Anmeldenummer: 11743548.7
(22) Anmeldetag: 12.08.2011
(51) Int. Cl.: H01L 21/683, H01L 21/687

(54) **AUFNAHMEEINRICHTUNG ZUR AUFNAHME EINES STRUKTURIERTEN WAFERS**
HOLDING DEVICE FOR HOLDING A PATTERNED WAFER
SYSTÈME DE SUPPORT D'UNE TRANCHE STRUCTURÉE

(43) Veröffentlichungstag der Anmeldung: 14.05.2014
(73) Patentinhaber: Ev Group E. Thallner GmbH, 4782 St. Florian am Inn (AT)
(72) Erfinder: THALLNER, Werner, A-4783 St. Florian (AT); BURGSTALLER, Daniel, 4910 Neuhofen/Innkreis (AT)
(74) Vertreter: Schweiger, Johannes
(86) Internationale Anmeldenummer: PCT/EP2011/063963
(87) Internationale Veröffentlichungsnummer: WO 2013/023680

(56) Entgegenhaltungen:
- EP-A1- 0 488 722
- JP-A- 2005 116 842
- US-A1- 2002 166 625
- US-A1- 2005 036 267
- US-A1- 2007 152 690
- US-A1- 2008 146 124
- US-A1- 2008 276 864
- US-A1- 2009 269 490

## Beschreibung

Die vorliegende Erfindung betrifft ein Verfahren für eine Aufnahmeeinrichtung zur Aufnahme eines Substrats, insbesondere Wafers, an einer Strukturen aufweisenden Strukturseite des Substrats gemäß Patentanspruch 1.

Die Druckschrift JP 42288133 zeigt eine Aufnahmeeinrichtung zur Aufnahme **eines** Wafers mit einem beweglichen Mitteilteil. Ferner zeigt die Druckschrift US 2008/146124 A1 eine Aufnahmeeinrichtung für strukturbehaftete Substrate.

Solche Aufnahmeeinrichtungen werden als "Chucks" in der Halbleiterindustrie verwendet, insbesondere zur Handhabung von Wafern bei der Herstellung elektrischer Komponenten in verschiedenen Prozessschritten. Die mit einzelnen Bauteilgruppen (Strukturen) versehenen Wafer werden auch als Produktwafer bezeichnet. In jedem Prozessschritt kommt es darauf an, dass die Wafer schnell, sicher und leicht lösbar an der Aufnahmeeinrichtung fixiert werden, damit die Handhabung der Wafer kein Störfaktor für die Bearbeitung des Wafers ist. Die Fixierung der Strukturen aufweisenden Produktwafer wird umso schwieriger, je dünner sie sind und je ausgeprägter und höher die Topografie der Bauelemente auf den Produktwafern ist. Jeder Stress im Wafer soll möglichst vermieden werden, damit die teilweise sehr teuren, auf dem Produktwafer vorhandenen Strukturen nicht beschädigt werden. Während für die Fixierung eines Produktwafers auf der nicht strukturierten, also flachen Seite verschiedene Lösungsansätze vorhanden sind, besteht bei der Fixierung eines Produktwafers auf seiner strukturierten Seite eine Vielzahl technischer Probleme. So ist beispielsweise eine elektrostatische Fixierung problematisch, da die elektrischen Schaltungen der Strukturen durch etwaige Spannungsspitzen zerstört werden können.

Weiterhin sollen die elektrischen Strukturen möglichst kontaminationsfrei und ohne Verunreinigung (beispielsweise durch Kleber) handhabbar sein. Aufgabe der vorliegenden Erfindung ist es daher, eine Aufnahmeeinrichtung zur Aufnahme und Handhabung sowie Fixierung eines Substrats vorzusehen, bei der eine schnelle, sichere und schonende sowie reversible und leicht steuerbare Aufnahme und Fixierung des Substrats ermöglicht wird.

Diese Aufgabe wird mit den Merkmalen des Patentanspruchs 1 gelöst.

Der Erfindung liegt der Gedanke zugrunde, bekannte Vakuumchucks derart weiterzubilden, dass Strukturen des Substrats derart mit in die das Substrat ansaugende Fluidströmung einbezogen werden, dass eine gleichmäßige und über die gesamte Strukturseite des Substrats möglichst homogene Ansaugwirkung (Ansaugdruck) ermöglicht wird. Mit anderen Worten ermöglicht die erfindungsgemäße Aufnahmeeinrichtung eine, insbesondere linear variierbare, homogene Flächenkraft auf den Produktwafer, so dass das Substrat auf dem Vakuumprobenhalter (Aufnahmeeinrichtung) mit der gewünschten Flächenkraft aufnehmbar ist. Vorzugsweise ist die an dem Substrat wirkende Flächenkraft durch Änderung des Ansaugdrucks in linearer Abhängigkeit steuerbar. Die Flächenkraft wird durch die Ansaugfläche F₂ definiert.

Im Unterschied zu Vakuumchucks aus dem Stand der Technik ist bei der vorliegenden Erfindung keine vollflächige Druckbeaufschlagung entlang des Substrats vorgesehen, sondern eine Ansaugung ist ausschließlich im Bereich einer äußeren Ringfläche der Aufnahmefläche der Aufnahmeeinrichtung vorgesehen. Es hat sich herausgestellt, dass sich durch die erfindungsgemäße Ausgestaltung eine äußerst homogene Druckverteilung entlang der Aufnahmefläche der Aufnahmeeinrichtung, insbesondere auch außerhalb der Ansaugfläche, ergibt.

Gemäß einer vorteilhaften Ausführungsform der Erfindung ist vorgesehen, dass die, insbesondere als Kreisring ausgebildete, äußere Ringfläche sich von einem Umfangsrand der Aufnahmefläche in Richtung einer Mitte M der Aufnahmefläche erstreckt und eine, insbesondere maximale oder mittlere, Ringbreite R der äußeren Ringfläche kleiner 1/2 insbesondere kleiner 1/5, vorzugsweise kleiner 1/10, noch bevorzugter kleiner als 1/100, eines Durchmessers D₃ der Aufnahmefläche ist. Je dünner die Ringbreite R im Verhältnis zum Durchmesser D₃ beziehungsweise der verbleibenden Aufnahmefläche ist und/oder je weiter am Umfangsrand der Aufnahmefläche beziehungsweise am Umfang des Substrats wirkend die Ansaugfläche vorgesehen ist, desto homogener ist überraschender Weise die Druckverteilung entlang der (gesamten) Aufnahmefläche.

Mit Fᵢ wird im Weiteren die i-te Fläche, die sich aus den Flächenparametern, bei kreisrunder Fläche Fᵢ im speziellen aus dem Kreisdurchmesser Dᵢ, ergibt, bezeichnet. Handelt es sich um eine Menge von j=1..N Bohrungen, so wird unter Fᵢ die Summe der Flächen der F_{i, j} Bohrungen verstanden.

Mit Vorteil wird die Fluidströmung durch einen Strömungskanal gebildet, der folgende Abschnitte aufweist:
- im Aufnahmeelement eine Vielzahl von in der Ansaugfläche F₂ endenden, insbesondere als Durchgangsbohrungen ausgebildeten, Ansaugkanälen,
- eine an die Ansaugkanäle an deren zur Ansaugfläche F₂ gegenüberliegenden Kanalenden angeschlossene Fluidkammer und
- mindestens einen an der Fluidkammer vorgesehenen Druckanschluss zum Anschluss einer steuerbaren Absaugeinrichtung.

Die Fluidkammer 6 dient dabei insbesondere als Puffer sowie gleichzeitig als Verteiler zur gleichmäßigen Ansaugung entlang der Ansaugfläche F₂, so dass mit Vorteil nur ein einziger Druckanschluss und eine einzige Pumpe benötigt werden, um die Aufnahmeeinrichtung zu betreiben.

Soweit die Ansaugfläche F₂ einstellbar ist, insbesondere durch zumindest teilweises Verschließens eines Teils der Ansaugkanäle, lässt sich die Aufnahmeeinrichtung für verschiedene Produktsubstrate mit unterschiedlichen Strukturen/Abmessungen (insbesondere die Höhe H der Strukturen ist relevant) verwenden. Das Verschließen der Ansaugkanäle kann insbesondere durch, vorzugsweise einzelne ansteuerbare, Ventile an/in den Ansaugkanälen erfolgen. Alternativ dazu ist es erfindungsgemäß denkbar, an dem zur Ansaugfläche F₂ abgewandten Ende der Ansaugkanäle eine rotierbare Scheibe mit Öffnungen im Bereich der Ansaugkanäle (korrespondierend zu der äußeren Ringfläche) vorzusehen. Auf diese Weise sind die Ansaugkanäle durch Rotation der rotierbaren Scheibe stufenlos von ganz offen bis ganz geschlossen verstellbar sind. Dadurch können alle Ansaugkanäle gleichzeitig und stufenlos verstellt werden.

Hierbei ist es außerdem von Vorteil, wenn die Fluidkammer durch ein dichtend mit dem Aufnahmeelement verbundenes Fluidkammerelement und das Aufnahmeelement gebildet ist. Somit ist die Fluidkammer auf einfache Art und Weise, insbesondere durch Fräsen einer Wannenform in das Fluidkammerelement, herstellbar. Die Wannenform umfasst eine, insbesondere kreiszylinderförmige, Ausnehmung mit einem Durchmesser größer als der maximale Abstand zwischen den Ansaugkanälen an deren der Fluidkammer zugewandten Ende. Das Fluidkammerelement besteht somit insbesondere aus einer ringförmigen Umfangswand und einer oberen Wand, die die Fluidkammer begrenzen. Das Fluidkammerelement wird mit dem Aufnahmeelement durch Verbindungselemente, insbesondere Schrauben, mit dem Aufnahmeelement dichtend verbunden. Als Dichtung ist vorzugsweise eine kreisringförmige Dichtung mit einem Durchmesser größer als der Durchmesser der Fluidkammer am Umfang der Fluidkammer zwischen dem Fluidkammerelement und dem Aufnahmeelement vorgesehen.

In einer weiteren vorteilhaften Ausführungsform der Erfindung ist vorgesehen, dass der Strömungskanal im Bereich der Fluidkammer einen mindestens gleich großen, insbesondere mindestens 5 mal, vorzugsweise 10 mal, noch bevorzugter mindestens 20 mal, größeren Strömungsquerschnitt aufweist wie die Ansaugfläche F₂ und/oder der Strömungsquerschnitt F₁ des Druckanschlusses. Die Fluidkammer dient somit gleichzeitig als Puffer und Sammelraum für das von den Ansaugkanälen einströmende Fluid.

Mit Vorteil ist weiterhin vorgesehen, dass die Ansaugfläche F₂ so gewählt oder einstellbar ist, dass diese im Wesentlichen einer Zuströmfläche Z eines zwischen der Aufnahmefläche und dem an der Aufnahmefläche aufgenommenen Substrat gebildeten Ringspalts entspricht. Der Ringspalt weist eine durch die Höhe der Strukturen des Substrats definierte Höhe H auf und verläuft am Umfang der Aufnahmefläche beziehungsweise am Umfang des Substrats im Wesentlichen in Form eines Kreiszylinders, so dass die Zuströmfläche Z aus dem Umfang des Substrats beziehungsweise der Aufnahmefläche und der Höhe H zumindest näherungsweise berechenbar ist.

Gemäß einer weiteren, vorteilhaften Ausführungsform ist vorgesehen, dass die Aufnahmefläche an einem Vorsprung des Aufnahmeelements vorgesehen ist, dessen Kontur so gewählt ist, dass sie im wesentlichen der Flächenkontur der zu verarbeitenden Substrate entspricht, insbesondere mit einem Durchmesser D₃ der Aufnahmefläche zwischen 200 mm und 450 mm, vorzugsweise genau 200 mm oder 300 mm oder 450 mm. Durch diese Maßnahme wird die Zuströmfläche Z schärfer definiert, da diese an der quasi gemeinsamen Außenkontur zwischen der Aufnahmefläche und der die Konturen aufweisenden Oberfläche des Substrats entspricht.

Soweit die Aufnahmefläche, insbesondere der Vorsprung, mit einer, insbesondere elastischen, Schicht beschichtet ist, werden die auf dem Substrat vorhandenen Strukturen einerseits schonend auf der Aufnahmefläche aufgenommen und andererseits wird eine Kontamination (beispielsweise mit Metallabrieb) vermieden.

Indem eine erste Gruppe von, insbesondere mindestens 10, vorzugsweise mindestens 50, noch bevorzugter mindestens 100, Ansaugkanälen auf einem gemeinsamen ersten Kreis auf der äußeren Ringfläche, insbesondere zueinander äquidistant, liegen, wird das Ansaugen weiter homogenisiert. Denn durch eine konzentrische Anordnung der Ansaugkanäle zur Mitte M der Ansaugfläche beziehungsweise rotationssymmetrisch zu dem Aufnahmeelement wird eine gleichmäßige Fluidströmung, insbesondere zwischen der Aufnahmefläche und dem Substrat bis hin zur Mitte M der Aufnahmefläche bewirkt.

Gemäß einem weiteren Aspekt der vorliegenden Erfindung ist der Abstand zwischen den Ansaugkanälen kleiner als 1mm, insbesondere kleiner als 500µm, vorzugsweise kleiner als 250µm, noch bevorzugter kleiner als 150µm.

Dabei ist es von besonderem Vorteil, wenn eine zweite Gruppe von, insbesondere mindestens 10, vorzugsweise mindestens 20, Ansaugkanälen, insbesondere versetzt zu den Ansaugkanälen der ersten Gruppe angeordnet, auf einem gemeinsamen zweiten Kreis mit einem kleineren Radius als der erste Kreis auf der äußeren Ringfläche, insbesondere konzentrisch zu der Mitte M und/oder äquidistant zueinander, liegt. Auf diese Weise können auf der äußeren Ringfläche mehr Ansäugkanäle untergebracht werden und je mehr Ansaugkanäle vorgesehen sind, desto kleiner können diese ausgebildet sein und desto gleichmäßiger und schonender erfolgt das Ansaugen des Substrats. Gleichzeitig wird durch die Anordnung mindestens zweier Gruppen an der äußeren Ringfläche eine höhere Stabilität des Aufnahmeelements erreicht. Nach oben ist die Anzahl der Ansaugkanäle folglich nur durch den minimalen Durchmesser der Ansaugkanäle und die Abmessungen des Aufnahmeelements beschränkt. Die versetzten Bohrungen sind damit ein Ersatz für einen Schlitz, welcher sich nachteilig auf die mechanische Stabilität des Wafers am Rand auswirken würde.

Gemäß einem weiteren Aspekt der vorliegenden Erfindung ist die Zuströmfläche Z durch Änderung, insbesondere Steuerung, des Durchmessers D₂ᵢ jedes Ansaugkanals denkbar.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen:
- Fig. 1a: eine Aufsicht auf eine erfindungsgemäße Aufnahmeeinrichtung von unten mit einer Schnittlinie A-A,
- Fig. 1b: eine Querschnittsansicht gemäß Schnittlinie A-A aus Figur 1a,

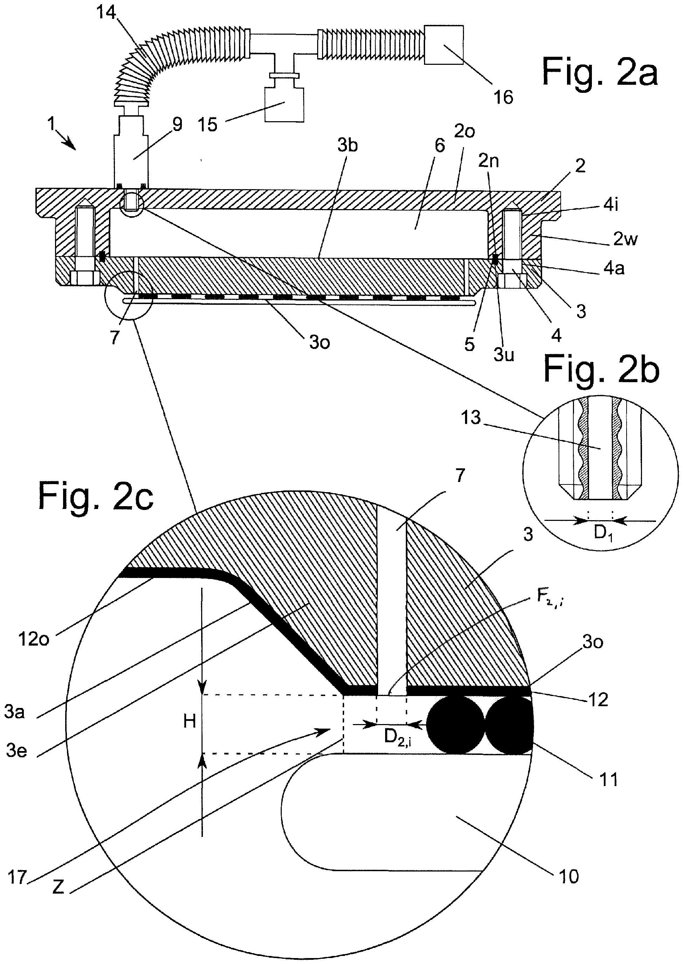

- Fig. 2a: eine Ansicht gemäß Figur 1b mit einem an der Aufnahmeeinrichtung aufgenommenen strukturierten Substrat,
- Fig. 2b: eine Detailansicht aus Figur 2a und
- Fig. 2c: eine Detailansicht aus Figur 2a.

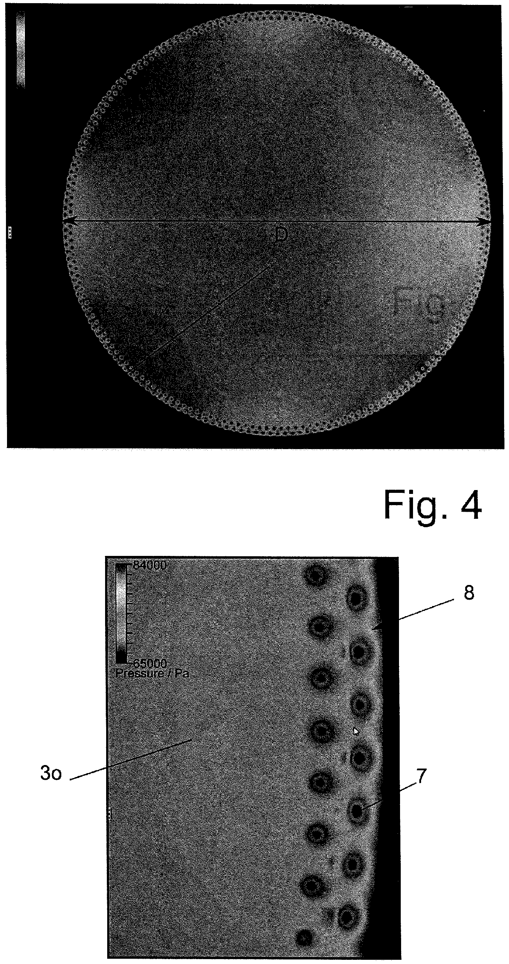

- Fig. 3: eine Konturplotansicht der Druckverteilung der Oberfläche 3o, berechnet mit einem Fluidsimulationsprogramm
- Fig. 4: eine Vergrößerung der Konturplotansicht der Druckverteilung der Oberfläche 3o, berechnet mit einem Fluidsimulationsprogramm

In den Figuren sind gleiche oder gleichwirkende Bauteile mit den gleichen Bezugszeichen gekennzeichnet.

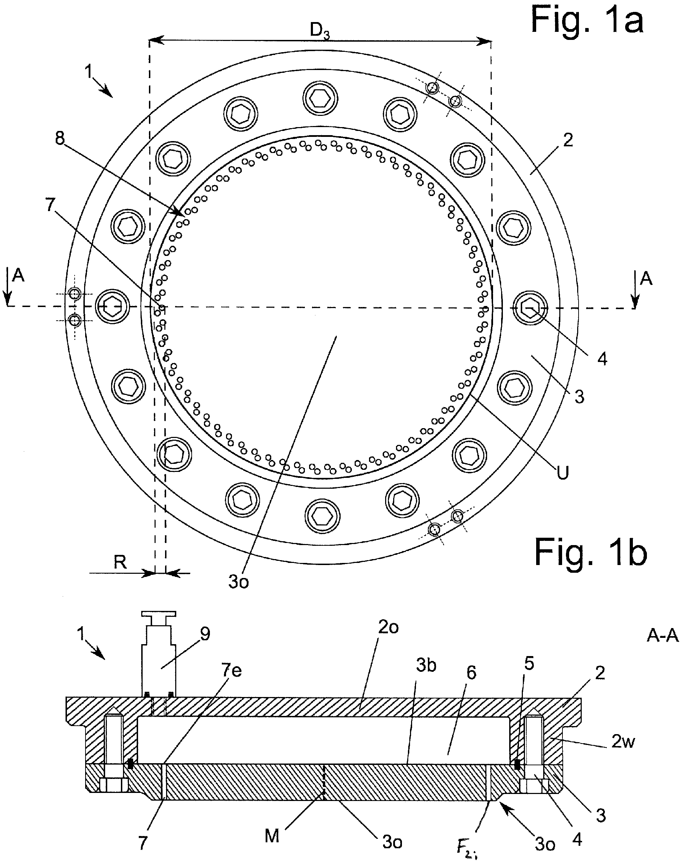

Figur 1a zeigt eine Aufnahmeeinrichtung 1, die aus einem Fluidkammerelement 2 und einem Aufnahmeelement 3 besteht. Das Fluidkammerelement 2 besteht aus einer durch Ausfräsen eines Kreiszylinders gebildeten, ringförmigen Umfangswand 2w und einer die ringförmige Umfangswand 2w bedeckenden oberen Wand 2o. Die obere Wand 2o bildet gleichzeitig den Boden des ausgefrästen Zylinders. Zur Fixierung des Aufnahmeelements 3 an dem Fluidkammerelement 2 werden bei der Herstellung des Fluidkammerelements 2 Innengewinde 4i in die Umfangswand 2w geschnitten, und zwar am Umfang der Umfangswand 2w äquidistant zueinander verteilt. Bei der Herstellung des Fluidkammerelements 2 wird weiterhin mindestens eine Dichtungsnut 2n an der Verbindungsfläche zwischen dem Fluidkammerelement 2 und dem Aufnahmeelement 3 vorgesehen. Bei der Herstellung des Fluidkammerelements 2 wird außerdem ein Druckanschluss 13 in der oberen Wand 2o vorgesehen. An dem Druckanschluss 13 ist ein Anschlusselement 9 dichtend angeschlossen beziehungsweise anschließbar und dieses dient zum Anschluss eines Saugrohrs 14, das mit einer Pumpe 16 verbunden ist. In dem Saugrohr 14 können eines oder mehrere Messgeräte 15 zur Druckmessung vorgesehen sein. Die Druckmessung kann auch in der Pumpe 16 und/oder an einer anderen Position im Strömungskanal erfolgen.

Der Druckanschluss 13 weist einen Strömungsquerschnitt F₁, insbesondere als Bohrung mit einem Durchmesser D₁, auf. Der Druckanschluss 13 ist Teil eines durch die Aufnahmeeinrichtung 1 verlaufenden Strömungskanals. Der Druckanschluss 13 (und somit der Strömungskanal) führt zu einer durch die obere Wand 2o und die Umfangswand 2w und eine Befestigungsseite 3b des Aufnahmeelements 3 gebildeten Fluidkammer 6.

Das Aufnahmeelement 3 hat im wesentlichen eine Zylinderform mit einem zum Fluidkammerelement 2, insbesondere zur Umfangswand 2w, entsprechenden Außenumfang, so dass das Aufnahmeelement 3 mit seiner, insbesondere ebenen, Befestigungsseite 3b an einer Kontaktfläche mit dem Fluidkammerelement 2 dichtend verbindbar ist. Hierzu sind zu den Innengewinden 4i korrespondierend angeordnete Schraubenaufnahmen 4a zur Aufnahme von als Schrauben ausgebildeten Verbindungselementen 4 vorgesehen. Durch die Verbindungselemente 4 ist das Aufnahmeelement 3 an dem Fluidkammerelement 2 an deren gemeinsamer Kontaktfläche fixierbar, wobei eine als Ringdichtung ausgebildete Dichtung 5 in der Dichtungsnut 2n sowie gegebenenfalls einer korrespondierenden Dichtungsnut 3n des Aufnahmeelements 4 zur Abdichtung der Fluidkammer 6 gegenüber der Umgebung vorgesehen ist.

Die Fluidkammer 6 bildet einen weiteren Abschnitt des Strömungskanals. Ausgehend von der Fluidkammer 6 wird der Strömungskanal in einem durch eine Vielzahl von in dem Aufnahmeelement 3 vorgesehenen Ansaugkanälen 7 gebildeten weiteren Abschnitt des Strömungskanals aufgeteilt beziehungsweise verzweigt.

Die Ansaugkanäle sind als, insbesondere parallel zueinander verlaufende, Durchgangsbohrungen ausgebildet, deren Enden 7e alle an beziehungsweise innerhalb der Fluidkammer 6 enden. Das gegenüberliegende Ende der Ansaugkanäle endet im Bereich einer äußeren Ringfläche 8 einer Aufnahmefläche 3o zur Aufnahme eines Substrats 10. Die Aufnahmefläche 3o ist an einem Vorsprung 3e vorgesehen, der als Kreisring mit einem Durchmesser D₃ und einem schräg verlaufenden Absatz 3a ausgebildet ist. Der Durchmesser D₃ entspricht im Wesentlichen dem Durchmesser des Substrats 10.

Eine erste Gruppe von Ansaugkanälen 7 ist auf einem Kreis und innerhalb der äußeren Ringfläche 8 angeordnet, während eine zweite Gruppe von Ansaugkanälen auf einem weiter innen liegenden zweiten Kreis und ebenfalls innerhalb der äußeren Ringfläche 8 angeordnet ist. Somit werden möglichst viele Ansaugkanäle 7 mit einem möglichst kleinen Durchmesser D₂ möglichst nahe an einem Umfangsrand U der Aufnahmefläche 3o untergebracht. Durch die Dicke des Aufnahmeelements 3 bleibt ein innerhalb der äußeren Ringfläche 8 vorgesehener Auflageabschnitt der Aufnahmefläche 3o stabil. Im Auflageabschnitt sind keine Ansaugkanäle 7 vorgesehen und der Auflageabschnitt beziehungsweise die gesamte Aufnahmefläche 3o sind plan eben ausgebildet.

Die Oberfläche des Aufnahmeelements 3 kann zumindest teilweise, insbesondere im Bereich der Aufnahmefläche 3o, mit einer Beschichtung 12 aus weichem Material beschichtet sein. Vorzugsweise handelt es sich um ein Polymer, mit Vorzug um ein Elastomer. Die Beschichtung 12 dient zur Schonung von auf dem Substrat 10 vorgesehenen, empfindlichen Strukturen 11 sowie zur Vermeidung von Kontamination des als Produktsubstrat ausgebildeten Substrats 10.

Die Ansaugkanäle 7, die durch Bohrung hergestellt werden, sind konzentrisch zu einer Mitte M des, insbesondere rotationssymmetrischen, Aufnahmeelements 3 angeordnet.

Eine Ringbreite R der äußeren Ringfläche 8 ist möglichst klein ausgebildet und möglichst weit am Umfangsrand U angeordnet und liegt insbesondere zwischen 1 mm und 50 mm, vorzugsweise zwischen 1 mm und 10 mm. Der Durchmesser D₃ beträgt insbesondere zwischen 200 mm und 450 mm, vorzugsweise genau 200 mm, 300 mm oder 450 mm.

Durch kontinuierliches Beaufschlagen der Fluidkammer 6 mit einem Unterdruck über den Druckanschluss 13 und die Pumpe 16 entsteht an einer durch die Summe der Strömungsquerschnitte der Ansaugkanäle 7 an der Aufnahmefläche 3o gebildete Ansaugfläche F₂ eine Sogwirkung. Auf diese Weise kann das Substrat 10 mit seiner Strukturseite 10s an die Aufnahmefläche 3o angesaugt und fixiert werden. Obwohl die Ansaugkanäle 7 nur an der äußeren Ringfläche 8 (Kreisring) vorgesehen sind, wird auch der innerhalb der äußeren Ringfläche 8 und zwischen der Aufnahmefläche 3o und dem Substrat 10 liegende, von Strukturen 11 durchsetzte Bereich evakuiert beziehungsweise mit Unterdruck beaufschlagt, der überraschend homogen ist. Die homogene Druckverteilung erklärt man sich am einfachsten dadurch, dass sich das statistische Vielteilchensystem in diesem Bereich als großkanonisches Ensemble auffassen lässt. Ein Ensemble ist eine Menge von Replika eines statistischen Vielteilchensystems, welche sich in ihren Mikrozuständen unterscheiden aber äquivalente Makrozustände besitzen. Ein großkanonisches Ensemble ist ein Ensemble, welches einer Teilchen- und Energiefluktuation unterliegt. Obwohl die erfindungsgemäße Ausführungsform kontinuierlich Teilchen am Rand absaugt, werden immer einige Teilchen den Weg in den inneren Bereich finden, ebenso wie Teilchen diesen Bereich auch wieder verlassen werden. Ein absolutes Vakuum, oder auch nur ein Hochvakuum, wird also niemals erzielbar sein. Dennoch kann die Menge an Teilchen, unter konstanten Anfangs und Randbedingungen im Mittel konstant gehalten werden. Da es keine Potentiale gibt, welche die statistische Verteilungsfunktion ortsabhängig machen (abgesehen vom Gravitationspotential, dessen Auswirkungen auf die Verteilungsfunktion für die geringe Höhe des betrachteten Bereichs, vernachlässigbar sind), muss die Druckverteilung ebenfalls eine homogene Funktion des Ortes sein. Somit wird das Substrat 10 mit den Strukturen 11 sehr gleichmäßig an die Aufnahmefläche 3o fixiert. Durch Steuerung des Unterdrucks an der Pumpe 16 und mittels der Strömungsquerschnitte der einzelnen Abschnitte des Strömungskanals wird die auf das Substrat 10 wirkende Kraft definiert.

Es hat sich erfindungsgemäß als optimal herausgestellt, wenn die Querschnittsfläche F₁ des Druckanschlusses 13 in etwa der Summe der Querschnittsflächen der Ansaugkanäle, also in etwa der Ansaugfläche F₂, entspricht. Das Verhältnis der Flächen F₁ zu F₂ liegt dabei insbesondere zwischen 1 zu 10 und 10 zu 1, mit Vorzug zwischen 2 zu 7 und 7 zu 2, mit größerem Vorzug zwischen 3 zu 5 und 5 zu 3, mit größtem Vorzug zwischen 4 zu 5 und 5 zu 4.

Die Ansaugfläche F₂ ist darüber hinaus mit Vorteil so gewählt, dass sie in etwa einer Zuströmfläche Z entspricht, die durch einen Ringspalt 17 zwischen dem Umfangsrand U der Aufnahmefläche 3o und dem Substrat 10 aufgrund der Höhe der Strukturen 11 beim Ansaugen gebildet wird. Die Zuströmfläche Z entspricht dabei dem Umfang des Ringspalts 17 multipliziert mit der Höhe H des Ringspalts 17, wobei insbesondere ein Verhältnis der Ansaugfläche F₂ zur Zuströmfläche Z zwischen 4 zu 5 und 5 zu 4 vorgesehen ist.

Solange das Substrat 10 an der Aufnahmeeinrichtung 1 gehalten werden soll, muss die Pumpe 16 für eine kontinuierliche Fluidströmung entlang des Strömungskanals sorgen. Durch die oben beschriebenen Strömungsquerschnitte des Strömungskanals ist erfindungsgemäß vorgesehen, dass die Gasmenge, welche pro Zeiteinheit durch die Ansaugkanäle 7 strömt, gleich ist mit der Gasmenge, welche die Fluidkammer 6 durch den Druckanschluss 13 beziehungsweise das Anschlusselement 9 verlässt.

Die topografischen Strukturen 11 halten das Substrat 10 (Wafer) in einem Abstand H (entspricht Höhe H des Ringspalts 17) von dem Vorsprung 3e, nämlich der Aufnahmefläche 3o, getrennt. Der Raum zwischen dem Substrat und der Aufnahmefläche 3o wird zu Beginn des Ansaugvorgangs automatisch auf ein bestimmtes Druckniveau etwas oberhalb des Ansaugdrucks an der Ansaugfläche F₂ abgesenkt und bleibt anschließend bei weiterer, kontinuierlicher Druckbeaufschlagung der Fluidkammer 6 konstant. Zu diesem Zeitpunkt liegt ein, insbesondere stationärer Druckverlauf entlang des Strömungsprofils von der Zuströmfläche Z bis zur Pumpe 16 vor.

Somit ist es erfindungsgemäß durch die Absaugleistung, insbesondere den Volumenstrom oder jede andere leicht zugänglich und messbare physikalische Größe, der Pumpe 16 steuerbar, wie groß die auf das Substrat 10 an der Aufnahmefläche 3o wirkende Flächenkraft ist, wobei durch die Änderung der Absaugleistung eine mit Vorzug lineare Änderung der Flächenkraft erfolgt. Gemäß einer weiteren Ausführungsform der Erfindung ist vorgesehen, dass die elastische Beschichtung 12 derart elastisch ist, dass die Strukturen 11 zumindest teilweise, insbesondere mindestens um ein Drittel der Höhe H, vorzugsweise um die Hälfte der Höhe H, noch bevorzugter um dreiviertel der Höhe H in die elastische Beschichtung 12 eindringen. Hierdurch wird die Höhe H' des Ringspalts 17 verringert, so dass auch die Zuströmfläche Z' entsprechend kleiner wird. Das könnte einen sich verstärkenden Effekt zur Folge haben. Eine kleinere Zuströmfläche Z' bei gleichem Volumenstrom würde eine höhere Kraft bedeuten und damit den Wafer weiter in die Beschichtung 12 drücken, was wiederum eine Verringerung der Zuströmfläche Z' zur Folge hätte.

Gemäß einer weiteren vorteilhaften Ausführungsform der Erfindung, insbesondere in Kombination mit der im vorhergehenden Absatz beschriebenen Ausführungsform, ist es erfindungsgemäß denkbar, die Ansaugkanäle 7 zumindest teilweise verschließbar auszugestalten. Dadurch hätte man eine dynamische Anpassungsmöglichkeit für die Zuströmfläche Z'.

Aufnahmeeinrichtung zur Aufnahme eines strukturierten Wafers

### Bezugszeichenliste

- 1: Aufnahmeeinrichtung
- 2: Fluidkammerelement
- 2w: Umfangswand
- 2o: obere Wand
- 2n: Dichtungsnut
- 3: Aufnahmeelement
- 3o: Aufnahmefläche
- 3e: Vorsprung
- 3b: Befestigungsseite
- 3n: Dichtungsnut
- 4: Verbindungselemente
- 4i: Innengewinde
- 4a: Schraubenaufnahme
- 5: Dichtung
- 6: Fluidkammer
- 7: Ansaugkanäle
- 7e: Enden
- 8: äußere Ringfläche
- 9: Anschlusselement
- 10: Substrat
- 10s: Strukturseite
- 11: Strukturen
- 12: Beschichtung
- 13: Druckanschluss
- 14: Saugrohr
- 15: Messgerät
- 16: Pumpe
- 17: Ringspalt
- F₁: Strömungsquerschnitt
- F₂: Ansaugfläche
- U: Umfangswand
- M: Mitte
- R: Ringbreite
- D₁: Durchmesser
- D₂: Durchmesser
- D₃: Durchmesser
- Z: Zuströmfläche
- H: Höhe

## Patentansprüche

1. Verfahren zur Aufnahme und Fixierung eines Substrats (10) an einer Strukturen (11) aufweisenden Strukturseite (10s) des Substrats (10) mittels einer Aufnahmeeinrichtung mit einem Aufnahmeelement (3) mit einer planen Aufnahmefläche (3o) zur Stützung der Strukturen (11) und einer die Aufnahmefläche (3o) ausschließlich in einer äußeren Ringfläche (8) durchsetzenden Ansaugfläche (F₂) durch eine das Substrat (10) ansaugende, kontinuierliche und steuerbare Fluidströmung, **dadurch gekennzeichnet, dass** das Substrat (10) von den Strukturen (11) in einen Abstand (H) von der Aufnahmefläche (3o) gehalten wird, wobei die ansaugende, kontinuierliche und steuerbare Fluidströmung in dem Raum zwischen dem Substrat (10) und der Aufnahmefläche (3o) erzeugt wird.

## Claims

1. Method for mounting and fixing of a substrate (10) on one structure side (10s) of the substrate (10), which side has structures (11), with a mounting apparatus with a mounting element (3) with a flat mounting surface (3o) for supporting the structures (11) and with a suction area (F₂) which penetrates the mounting surface (3o) solely in an outer ring surface (8) through a continuously and controllable fluid flow, which suctions the substrate (10), **characterized in that** the substrate (10) is kept by the structures (11) separated at a distance (H) from the mounting surface (3o), wherein the continuously and controllable fluid flow, which suctions the substrate (10), is produced in the space between the substrate (10) and the mounting surface (3o).

## Revendications

1. Procédé pour recevoir et fixer un substrat (10) sur un côté structuré (10s) du substrat (10) présentant des structures (11) au moyen d'un dispositif de réception avec un élément de réception (3) avec une surface de réception (3o) plane pour appuyer les structures (11) et une surface d'aspiration (F₂) traversant la surface de réception (3o) exclusivement dans une surface annulaire (8) extérieure par un écoulement fluidique continu et pouvant être commandé, aspirant le substrat (10), **caractérisé en ce que** le substrat (10) est maintenu par les structures (11) à une distance (H) de la surface de réception (3o), dans lequel l'écoulement fluidique aspirant, continu et pouvant être commandé est produit dans l'espace entre le substrat (10) et la surface de réception (3o).
